# EUROPÄISCHE PATENTANMELDUNG

(11) **EP 0 886 464 A2**
(43) Veröffentlichungstag der Anmeldung: **23.12.1998**
(21) Anmeldenummer: 98111043.0
(22) Anmeldetag: 16.06.1998
(51) Int. Cl.: H05K 9/00

(54) **Schirmung**

(30) Priorität: 18.06.1997 DE 29710640 U
(71) Anmelder: SIEMENS AKTIENGESELLSCHAFT, 80333 München (DE)
(72) Erfinder: Lepping, Jürgen, 45359 Essen (DE); Sölter, Achim, 46399 Bocholt (DE)

(57) **Zusammenfassung**

Die Erfindung betrifft eine Schirmung (1) für elektrische Schaltkreise, insbesondere auf Leiterplatten. Erfindungsgemäß vorgesehen ist einen Schirmrahmen (2) mit umlaufend angeordneten domartigen Zapfen (4) zur Verrastung mit Rasthaken (5) in einem Schirmdeckel (3), wobei der Abstand zwischen den Zapfen (3) durch die geforderte HF-Dichtigkeit bestimmt ist.

## Beschreibung

Die Erfindung betrifft eine Schirmung gemäß dem Oberbegriff des Patentanspruchs.

Abschirmgehäuse in unterschiedlichen Ausführungsformen werden zur Schirmung gegen störende HF-Einstrahlung beziehungsweise -Abstrahlung auf beziehungsweise von elektrischen Schaltkreisen verwendet. Eine Störstrahlung führt zur Überschreitung von Grenzwerten und zu Fehlfunktionen des Gerätes. Besonders problematisch ist die Einstreuung der Sendeenergie in empfindliche Schaltungsteile bei einem Mobilfunkgerät. Weiter ist dabei die Abstrahlung von Oberwellen interner Oszillatoren und Verstärkerstufen bei sehr hohen Frequenzen von 5 bis 10 Gigahertz äußerst kritisch.

Bei der Seiterplattenherstellung wird zur Schirmung zuerst ein Abschirmrahmen aufgelötet beziehungsweise aufgeschraubt, und in einem zweiten Arbeitsgang wird dann ein Blechteil als Deckel aufgepreßt. Eine gute Schirmung versucht man insbesondere durch eine Verkrallung des Schirmdeckels an den Außenwandflächen des Schirmrahmens zu erreichen. Als weitere Lösungsmöglichkeiten wären beispielsweise ein Verlöten der kompletten Schirmung, ein Verschrauben der Schirmwanne mit den Leiterplatten oder ein Verkleben mit Leitkleber denkbar. Diese Lösungen sind aber sehr kostenaufwendig.

Bei Massenprodukten, beispielsweise bei Mobilfunkgeräten, kann aufgrund der Toleranzen der Schirmung sowie der Leiterplatte ein gleichmäßig guter Kontakt des Schirmrahmens mit dem Schirmdeckel nicht immer gewährleistet werden. Zudem ist der korrekte Sitz der Schirmung durch den seitlich überlappenden Deckel optisch schwer erkennbar.

Der Erfindung liegt die Aufgabe zu Grunde eine Schirmung anzugeben, die eine gute Dichtigkeit gegenüber der HF-Strahlung aufweist und dabei kostengünstig herstellbar ist.

Diese Aufgabe wird erfindungsgemäß durch die im Patentanspruch angegebenen Merkmale gelöst.

Bei der erfindungsgemäßen Schirmung ist eine optische Kontrolle auf HF-Dichtigkeit leicht durchführbar.

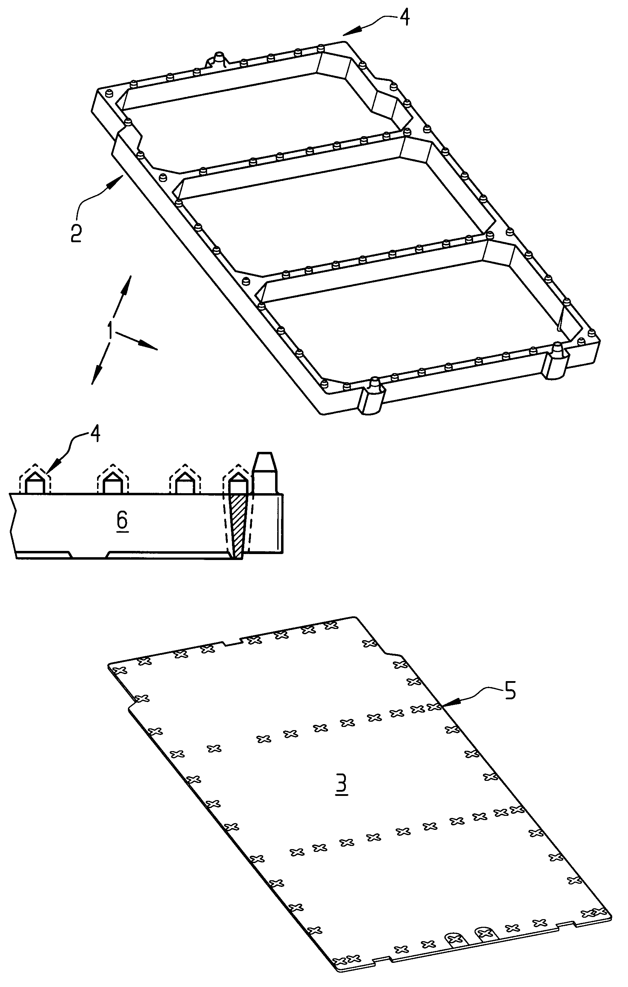

Im folgenden wird die Erfindung anhand eines in der Zeichnung dargestellten Ausführungsbeispieles beschrieben.

In der einzigen Figur ist eine Schirmung 1 dargestellt. Die Schirmung 1 weist einen Schirmrahmen 2 auf, an dem ein Schirmdeckel 3 befestigt wird.

Erfindungsgemäß weist der Schirmrahmen 2 umlaufende domartige Zapfen 4 auf, die in Rasthaken 5 des Schirmdeckels 3 eingreifen.

Die Zapfen 4 sind vorzugsweise mindestens auf einer Seite des Schirmrahmens 2 angeordnet. Sie können auch auf innerhalb des Schirmrahmens angeordneten Schirmwänden 6 vorgesehen sein.

Um eine HF-Dichtigkeit zu gewähren, muß der Schirmdeckel 3 möglichst gut mit dem Schirmrahmen 2 elektrisch kontaktiert sein. Der Abstand der Kontaktierungen ist von der zu schirmenden Frequenz abhängig.

Bereiche mit besonders empfindlichen Schaltungsteilen oder Bereiche mit sehr energiereicher HF-Abstrahlung werden erfindungsgemäß häufiger kontaktiert als die vergleichsweise unkritischen Bereiche. Hierdurch kann der konstruktive Aufwand verringert werden. Weiter wird durch diese Vorgehensweise der notwendige Kontaktdruck beim Aufbringen des Deckels 3 auf den Rahmen 2 verringert.

Durch die auf dem Rahmen 2 befindlichen, umlaufenden Zapfen 4 kann ein einwandfreier Kontakt zum Deckel 3 hergestellt werden. Da der Deckel 3 keine seitlichen Biegekanten aufweist, kann der einwandfreie Sitz des Deckels auf dem Rahmen 2 optisch leicht erkannt werden.

## Patentansprüche

1. Schirmung (1) für elektrische Schaltkreise, insbesondere auf Leiterplatten,
gekennzeichnet durch einen Schirmrahmen (2) mit umlaufend angeordneten domartigen Zapfen (4) zur Verrastung mit Rasthaken (5) in einem Schirmdeckel (3), wobei der Abstand zwischen den Zapfen (3) durch die geforderte HF-Dichtigkeit bestimmt ist.
